# FASCICULE DE BREVET EUROPEEN

(11) **EP 3 223 199 B1**
(45) Date de publication et mention de la délivrance du brevet: **30.12.2020**
(21) Numéro de dépôt: 17165550.9
(22) Date de dépôt: 24.05.2011
(51) Int. Cl.: G06K 19/077, G06K 19/07

(54) **PROCÉDÉ DE RÉALISATION D'UN MODULE MULTIFONCTIONNEL ET DISPOSITIF LE COMPRENANT**
HERSTELLUNGSVERFAHREN EINES MULTIFUNKTIONSMODULS, UND DIESES MODUL UMFASSENDE VORRICHTUNG
METHOD FOR MANUFACTURING A MULTI-FUNCTIONAL MODULE AND DEVICE INCLUDING SAME

(30) Priorité: 27.05.2010 EP 10305560
(43) Date de publication de la demande: 27.09.2017
(62) Numéro(s) de document de la (des) demande(s) initiale(s) en application de l'article 76 CBE: 11721065.8 / 2 577 571
(73) Titulaire: Thales Dis France SA, 92190 Meudon (FR)
(72) Inventeur: FIDALGO, Jean-Christophe, 13881 GEMENOS Cedex (FR); LEIBENGUTH, Joseph, 13881 GEMENOS Cedex (FR)

(56) Documents cités:
- EP-A1- 1 411 467
- EP-A1- 2 068 274
- WO-A1-03/017195
- WO-A1-2004/034320
- WO-A1-2009/078214

## Description

L'invention concerne un procédé de réalisation d'un module multifonctionnel et dispositif le comprenant.

L'invention concerne la fabrication d'objets intelligents de type multi-composant se présentant sous toute forme, comme par exemple des cartes à circuit(s) intégré(s), des passeports, des inserts électroniques de faible épaisseur.

Plus particulièrement, selon un mode préféré, l'invention concerne un module à afficheur intégré et le dispositif le comprenant.

Elle a pour objectif de permettre une fabrication économique, simple d'objets multi-composants qui présentent de préférence de bonnes propriétés de résistance mécanique notamment à la flexion.

Les cartes multi-composants actuelles notamment des cartes avec batterie, microcontrôleur, afficheur, nécessitent de réaliser un insert comportant des pistes d'interconnexion gravées sous forme de circuit imprimé. Les composants sont ensuite reportés et connectés par soudure ou par colle conductrice le cas échéant. Le support a l'inconvénient d'être plutôt rigide et le procédé plutôt onéreux.

Le document US 2006/124350 décrit un procédé de fabrication d'un assemblage obtenu par la superposition de couches isolantes laminées ayant au moins une ouverture logeant un élément. L'élément est agencé de manière à ce qu'une face visible affleure la surface externe de l'assemblage. Dans un mode de réalisation l'assemblage comprend deux éléments présentant une face principale orientée dans des directions opposées. Il décrit en fait un corps isolant comportant des éléments électroniques intégrés dans des ouvertures.

Le document US 5 412 538 décrit un circuit imprimé comprenant un substrat portant des métallisations et des composants et une ouverture dans l'épaisseur du substrat pour comprendre un composant. Les composants électroniques sont montés de part et d'autre d'un substrat multicouches en ayant leur surface principale respective exposée vers l'extérieur.

Le document WO 2009/078214 décrit un transpondeur RFID comprenant des pistes ou des composants réalisées sur un substrat. Le transpondeur étant agencé autour d'un support, les composants se retrouvent agencés sur des faces opposées du support.

Le document EP2068274 A1 concerne une carte avec une première puce de la carte et un logement pour recevoir une puce additionnelle avec laquelle elle peut communiquer. La puce additionnelle peut accéder à une interface de communication externe de la carte directement ou via la première puce. Elle comprend des plages de contacts sur une face et des composants sur l'autre face.

Le document WO 03/017195 concerne un module de carte à puce multi-composants. Il comprend d'un côté d'un substrat polymère, une puce de circuit intégré et un autre composant tel qu'un afficheur. L'afficheur est connecté à la puce de circuit intégré.

L'invention a pour objectif de résoudre les inconvénients précités.

L'invention a pour objectif un procédé de réalisation d'un dispositif multi-composant selon les revendications 1 à 5.

La connexion permet une communication ou une alimentation et peut être de différents types connus soit électrique ou sans-contact (capacitif, couplage électromagnétique, optique...)

L'invention a également pour objet le dispositif correspondant ou obtenu par le procédé ci-dessus.

Le procédé est avantageux par rapport à l'art antérieur car il permet de réaliser un dispositif multifonctionnel notamment avec des fonctions d'affichage et/ou interrupteur et/ou biométrique par encartage en une seule opération d'un seul module.

D'autres particularités et avantages de l'invention apparaîtront à la lecture de la description faite à titre d'exemple non limitatif et en regard des dessins annexés sur lesquels :
- La figure 1 illustre schématiquement un module multifonctionnel conforme à un mode de réalisation de l'invention ;
- La figure 2 illustre une opération d'encartage du module dans un corps de carte à puce.

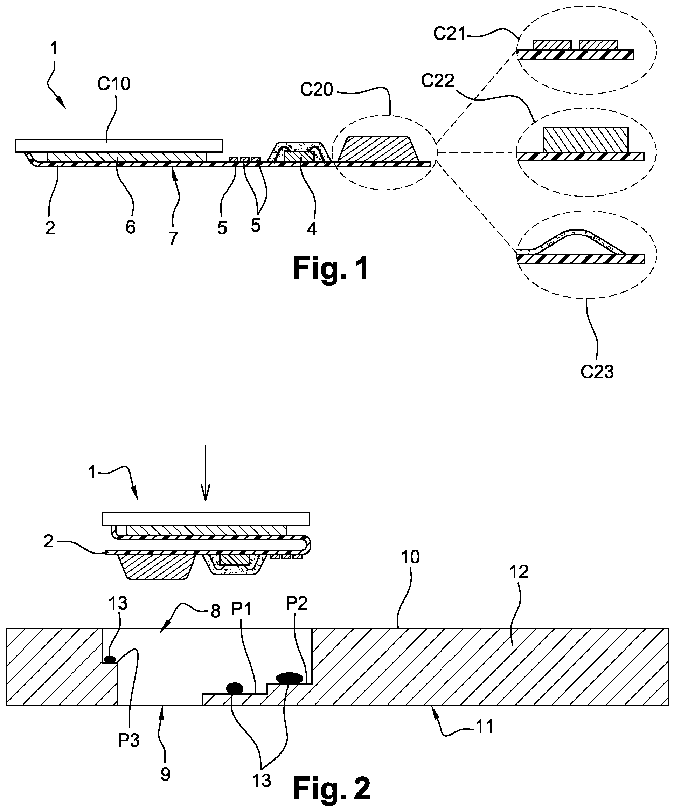

La figure 1 illustre conformément à un mode de mise en œuvre de l'invention, un dispositif ou module multifonctionnel ou à structure multi couches comportant des composants électriques / électroniques disposés sur un substrat en couches superposées ; Dans l'exemple, le module comporte au moins deux composants distincts C1, C2 sur un substrat 2 et du même côté dans un premier temps. Les composants présentent chacun une de leur face principale F1, F2 exposée vers l'extérieur du module.

Le substrat est de préférence souple, et/ou fin de manière à pouvoir être replié sans détérioration au moins à température ambiante (23° C). De préférence, ils ont été interconnectés par au moins une piste d'interconnexion, réalisée par gravure ou tout autre moyen connu d'interconnexion, filaire ou autre.

Le dispositif multi-composant comporte ici un afficheur d'une part pour C10, et un capteur d'empreinte digitale C20 ; Alternativement, ces composants peuvent être remplacés par tout composant électronique ou électrique tel qu'une interface à contacts électriques ou à antenne C21, un capteur C22, un ou plusieurs boutons C23 ou d'autres composants non représentés.

Le dispositif comporte de préférence un microcontrôleur 4 ici sous forme de puce de circuit intégré pour piloter au moins l'un des composants.

Le dispositif peut comporter également des composants passifs 5 tels que résistance, capacité, etc.

Dans l'exemple, les composants sont tous disposés du même côté du substrat, mais ils pourraient être répartis sur les deux côtés opposés du substrat.

Le dispositif peut comporter également une batterie fine 6, souple ou rigide mais de faible surface. Elle est ici disposée sous l'écran entre le substrat et l'écran. L'écran peut être réalisé selon la technologie OLED, électrophorétique, électrochromique ou type de technologie permettant de réaliser des afficheurs fins. On notera que le procédé proposé n'utilisant pas nécessairement une haute température, la gamme de technologie d'écran peut être plus large qu'avec un procédé traditionnel de lamination à chaud pour fabriquer la carte avec insert.

Par composant, on entend tout élément de circuit électrique ou électronique, électromécanique. Un simple contact peut aussi être considéré, dans certains cas comme un composant électrique de liaison.

Selon une caractéristique de l'invention, les composants sont agencés de manière à présenter leur face principale F1, F2 respective orientée dans des directions opposées l'une par rapport à l'autre.

Conformément à un mode de réalisation de l'exemple, à la figure 2, le module 1 est ensuite replié sur lui-même en deux; Dans l'exemple, c'est la face arrière qui est rabattue sur elle-même. Le cas échéant, on dispose un adhésif sur cette face arrière (opposée à la face avant portant les composants) pour maintenir le module en position replié. L'écran C10 fait par exemple une surface de 30 à 45 mm² et le composant C20 correspondant à la surface d'un module au standard ISO 7816 sensiblement un tiers de la surface de l'écran.

Dans sa configuration repliée, le module est plus compact ; Le pliage permet d'avoir des composants sur les deux faces opposées du module.

La configuration dépliée permet un report et une connexion plus aisée des différents composants.

Alternativement, les composants C20, 5 se retrouvant sur le côté arrière du substrat par rapport à la face principale portant le composant C10 peuvent être fixés sur la face arrière du substrat 7.

Encore alternativement, ces composants peuvent être réalisés séparément sur une portion de substrat distinct du substrat flexible 2 comme deux modules distincts qui sont ensuite assemblées par exemple dos à dos (face arrière contre face arrière). Des éventuelles interconnexions sont effectuées par tout moyen connu, notamment colle conductrice, film conducteur anisotropique (ACF), soudage par thermo compression, ultrasons. Les modules peuvent comprendre des pistes ou des connexions sur les deux faces principales ou des vias conducteurs à travers les substrats.

On a ainsi réalisé un module à structure multi couches comportant des composants électriques / électroniques disposés sur un substrat en couches superposées. De préférence, on utilise des technologies d'assemblage 3D de composants électroniques appelées communément « 3D SiP ».

Ensuite, le module est reporté dans un corps de carte à la manière de la technologie carte à puce.

Le corps de carte comporte deux faces principales 10, 11 opposées l'une à l'autre. Il comporte une première ouverture 8 débouchant à la face ou plan 10 et une seconde ouverture 9 débouchant sur la face ou plan 11 et conduisant à un logement commun 14. Les ouvertures 8, 9 ont des sections ou étendues différentes et correspondent respectivement à la surface des composants C10, C20 exposés à la surface ou visible sur ces surfaces.

Le logement 14 est dimensionné et configuré de manière à correspondre à l'encombrement du module 1 en état replié. L'ouverture 9 est dimensionnée et configurée de manière à laisser déboucher un composant C20 disposé sur la face arrière du module (ici sous l'écran) lorsque le module est logé dans le logement.

Le logement présente un ou plusieurs plans support P1, P2, P3 destiné (s) à caler et coller le module ; à cet effet, un adhésif 13 est dispensé sur les plans sous forme de goutte de colle. La colle peut aussi être un adhésif solide activable par pression ou à chaud.

De préférence, le composant C10 présentant la plus grande surface est laissé apparent ou accessible sur une face du corps tandis que sur la face opposée du corps, au moins un composant C20 de surface plus petite que celle de C10 est laissé apparent ou accessible.

Le module est ensuite reporté ou encarté dans le corps de carte de manière classique à la manière d'un module de carte à puce.

Le cas échéant, des feuilles de couverture transparente ou comportant une ouverture au moins au dessus des composants C10, 20 peuvent venir finir le dispositif. Dans un certain mode de réalisation, la cavité ne sera pas débouchante mais le fond de cavité pourra être transparent. On pourra dans ce mode de réalisation reporter le module avec l'afficheur vers le bas (dans le sens de la flèche fig.2), ce qui le rendra visible à travers le fond de cavité.

Le cas échéant, le dispositif comporte une antenne radiofréquence. Elle peut être dans le module et/ou le corps de carte. La connexion de l'antenne peut s'effectuer à la manière d'une carte duale contacts et sans contact). Par exemple, l'antenne du corps de carte présente des portions terminales de connexion parvenant dans la cavité du corps et accessible via une ou plusieurs ouvertures à la surface du corps de carte pour connecter un microcircuit lors du report du module dans la cavité.

La puce peut être apte à mettre en œuvre au moins une application logicielle mémorisée dedans pour réaliser une transaction électronique telle qu'un paiement bancaire, une opération de débit/crédit de points, d'unités, de fidélité, de contrôle d'accès, d'authentification, etc.

L'application peut être mise en œuvre par interaction avec un lecteur ou borne radiofréquence ou un autre dispositif du même genre que l'invention comportant une fonction ou puce électronique de type NFC (Near field communication) radiofréquence. Le dispositif lui-même peut être apte à réaliser une fonction NFC.

Le dispositif peut représenter également un document d'identité, passeport électronique ou être inclus dedans.

Dans l'application préférée à afficheur, l'invention est avantageuse en ce sens que le module à afficheur est réalisé par simple encartage comme un module de carte à puce. Le cas échéant le module ne comporte pas un autre composant débouchant ou visible sur l'autre face.

## Revendications

1. Procédé de réalisation d'un dispositif multi-composant, ledit procédé comprenant les étapes suivantes,
- réalisation d'un module (1) comportant au moins deux composants connectés entre eux sur au moins un substrat, lesdits composants comportant une puce de circuit intégré pour piloter au moins un autre composant (C10), C20), chacun ayant une face principale exposée vers l'extérieur du module,
- insertion du module (1) dans un corps (12) du dispositif, l'insertion s'effectuant par une ouverture (8) débouchant sur une face principale (10) du corps de dispositif et conduisant à un logement (14) ménagé dans le corps, afin d'exposer un composant (C10, C20) du module sur au moins une face (10, 11) du corps, pour une interaction directe visuelle ou tactile avec l'utilisateur,
**caractérisé en ce que** les composants sont agencés dans le module de manière à orienter leur face principale, dans des directions opposées l'une par rapport à l'autre.

2. Procédé selon la revendication 1, **caractérisé en ce que** les composants sont disposés sur deux faces opposées d'un substrat.

3. Procédé selon la revendication 1, **caractérisé en ce que** les composants sont disposés sur la même face d'un substrat qui est replié en deux.

4. Procédé selon la revendication 1, **caractérisé en ce que** les composants sont disposés chacun sur des substrats distincts assemblés ensuite dos à dos.

5. Procédé selon l'une des revendications précédentes, **caractérisé en ce que** l'insertion s'effectue par une ouverture (8)débouchant sur une face principale (10) du corps de dispositif et conduisant à un logement (14) ménagé dans le corps de manière à faire déboucher ou exposer un composant (C10, C20) du module sur chaque face (10, 11) opposée du corps pour une interaction visuelle ou tactile directe avec un utilisateur.

6. Dispositif multi-composants comprenant un module (1), ledit module comportant au moins deux composants connectés entre eux sur au moins un substrat, lesdits composants comportant une puce de circuit intégré pour piloter au moins un autre composant (C10, C20), ledit module (1) étant inséré dans un corps (12) du dispositif via une ouverture (8) débouchant sur une face principale (10) du corps de dispositif et conduisant à un logement (14) ménagé dans le corps, afin d'exposer un composant (C10, C20) du module sur au moins une face (10, 11) du corps pour une interaction directe visuelle ou tactile avec l'utilisateur, **caractérisé en ce que** les composants sont agencés dans le module de manière à orienter leur face principale dans des directions opposées l'une par rapport à l'autre.

7. Dispositif selon la revendication 6. **caractérisé en ce que** les composants sont disposés sur deux faces opposées d'un substrat.

8. Dispositif selon la revendication 6. **caractérisé en ce que** les composants sont disposés sur la même face d'un substrat qui est replié en deux.

9. Dispositif selon l'une des revendications 6 à 8, **caractérisé en ce que** les composants sont disposés chacun sur des substrats distincts assemblés ensuite dos à dos.

10. Dispositif selon l'une des revendications 6 à 9, **caractérisé en ce que** le logement (14) débouche sur une ouverture sur chaque face principale opposée (10, 11) du corps (12) du dispositif.

11. Dispositif selon la revendication 10 **caractérisé en ce que** les ouvertures (8, 9) ont des étendues différentes l'une de l'autre.

## Patentansprüche

1. Herstellungsverfahren einer Multibauteilvorrichtung, wobei das Verfahren die folgenden Schritte umfasst,
- Herstellung eines Moduls (1), das mit mindestens zwei Bauteile umfasst, die miteinander auf mindestens einem Substrat verbunden sind, wobei die Bauteile einen Chip einer integrierten Schaltung umfassen, um mindestens ein anderes Bauteil (C10), C20), das jeweils eine Hauptfläche umfasst, die zu dem äußeren des Moduls exponiert ist, zu steuern,
- Einsetzen des Moduls (1) in einen Körper (12) der Vorrichtung, wobei das Einsetzen durch eine Öffnung (8) erfolgt, die auf einer Hauptfläche (10) des Vorrichtungskörpers mündet und zu einer Aufnahme (14) führt, die in dem Körper ausgebildet ist, um ein Bauteil (C10, C20) des Moduls auf mindestens einer Fläche (10, 11) des Körpers für eine direkte visuelle oder taktile Interaktion mit dem Benutzer freizulegen,
**dadurch gekennzeichnet, dass** die Bauteile in dem Modul derart angeordnet sind, dass sie ihre Hauptfläche in entgegengesetzte Richtungen zueinander ausrichten.

2. Verfahren nach Anspruch 1, **dadurch gekennzeichnet, dass** die Bauteile auf zwei entgegengesetzten Flächen eines Substrats angeordnet sind.

3. Verfahren nach Anspruch 1, **dadurch gekennzeichnet, dass** die Bauteile auf derselben Fläche eines Substrats, das in zwei Hälften gefaltet ist, angeordnet sind.

4. Verfahren nach Anspruch 1, **dadurch gekennzeichnet, dass** die Bauteile jeweils auf getrennten Substraten, die dann Rücken an Rücken zusammengebaut werden, angeordnet sind.

5. Verfahren nach einem der vorstehenden Ansprüche, **dadurch gekennzeichnet, dass** das Einführen durch eine Öffnung (8) erfolgt, die auf einer Hauptfläche (10) des Vorrichtungskörpers mündet und zu einer Aufnahme (14) führt, die in dem Vorrichtungskörper derart eingerichtet ist, dass sie ein Bauteil (C10, C20) des Moduls auf jeder entgegengesetzten Fläche (10, 11) des Körpers für eine direkte visuelle oder taktile Interaktion mit einem Benutzer münden lässt oder exponiert.

6. Multibauteilvorrichtung, die ein Modul (1) umfasst, wobei das Modul mindestens zwei Bauteile umfasst, die miteinander auf mindestens einem Substrat miteinander verbunden sind, wobei die Bauteile einen Chip einer integrierten Schaltung zum Steuern mindestens eines anderen Bauteils (C10, C20) umfassen,
wobei das genannte Modul (1) in einen Körper (12) der Vorrichtung über eine Öffnung (8), die auf einer Hauptfläche (10) des Vorrichtungskörpers mündet, eingeführt wird und zu einer Aufnahme (14), die in dem Körper eingerichtet ist, führt, um ein Bauteil (C10, C20) des Moduls auf mindestens einer Fläche (10, 11) des Körpers zur direkten visuellen oder taktilen Interaktion mit dem Benutzer zu exponieren,
**dadurch gekennzeichnet, dass** die Bauteile in dem Modul derart eingerichtet sind, dass sie ihre Hauptfläche in entgegengesetzten Richtungen zueinander ausrichten.

7. Vorrichtung nach Anspruch 6, **dadurch gekennzeichnet, dass** die Bauteile auf zwei entgegengesetzten Seiten eines Substrats angeordnet sind.

8. Vorrichtung nach Anspruch 6, **dadurch gekennzeichnet, dass** die Bauteile auf derselben Fläche eines Substrats, das in zwei Hälften gefaltet ist, angeordnet sind.

9. Vorrichtung nach einem der Ansprüche 6 bis 8, **dadurch gekennzeichnet, dass** die Bauteile jeweils auf getrennten Substraten angeordnet und dann Rücken an Rücken zusammengebaut sind.

10. Vorrichtung nach einem der Ansprüche 6 bis 9, **dadurch gekennzeichnet, dass** die Aufnahme (14) auf einer Öffnung auf jeder entgegengesetzten Hauptfläche (10, 11) des Körpers (12) der Vorrichtung mündet.

11. Vorrichtung nach Anspruch 10, **dadurch gekennzeichnet, dass** die Öffnungen (8, 9) voneinander unterschiedliche Ausdehnungen aufweisen.

## Claims

1. A method for manufacturing a multi-component device, said method comprising the following steps,
- manufacturing a module (1) having at least two components connected to each other on at least one substrate, said components having an integrated circuit chip for driving at least one other component (C10), C20), each having a main surface exposed to the outside of the module,
- inserting the module (1) into a body (12) of the device, the insertion being carried out through an opening (8) opening onto a main surface (10) of the device body and leading to a housing (14) formed in the body, in order to expose a component (C10, C20) of the module on at least one surface (10, 11) of the body, for direct visual or tactile interaction with the user,
**characterised in that** the components are arranged in the module so that the main surfaces thereof are oriented in mutually opposite directions.

2. The method according to Claim 1, **characterised in that** the components are arranged on two opposite surfaces of a substrate.

3. The method according to Claim 1, **characterised in that** the components are arranged on the same surface of a substrate which is folded in two.

4. The method according to Claim 1, **characterised in that** the components are each arranged on separate substrates, then assembled back to back.

5. The method according to one of the preceding claims, **characterised in that** the insertion is carried out through an opening (8) which opens onto a main surface (10) of the device body and which leads to a housing (14) formed in the body, so as to open or expose a component (C10, C20) of the module on each opposite surface (10, 11) of the body for direct visual or tactile interaction with a user.

6. A multi-component device comprising a module (1), said module including at least two components connected to each other on at least one substrate, said components including an integrated circuit chip for driving at least one other component (C10, C20),
said module (1) being inserted into a body (12) of the device via an opening (8) which opens onto a main surface (10) of the device body and which leads to a housing (14) formed in the body, in order to expose a component (C10, C20) of the module on at least one surface (10, 11) of the body for direct visual or tactile interaction with the user,
**characterised in that** the components are arranged in the module so that the main surfaces thereof are oriented in mutually opposite directions.

7. The device according to Claim 6, **characterised in that** the components are arranged on two opposite surfaces of a substrate.

8. The device according to Claim 6, **characterised in that** the components are arranged on the same surface of a substrate which is folded in two.

9. The device according to one of Claims 6 to 8, **characterised in that** the components are each arranged on separate substrates, then assembled back to back.

10. The device according to one of Claims 6 to 9, **characterised in that** the housing (14) opens onto an opening on each opposite main surface (10, 11) of the body (12) of the device.

11. The device according to Claim 10, **characterised in that** the openings (8, 9) have different extents from one another.
